(19) Europäisches Patentamt
European Patent Office
Office européen des brevets

(11) **EP 2 161 837 B1**

(12) **FASCICULE DE BREVET EUROPEEN**

(45) Date de publication et mention
de la délivrance du brevet:
**09.11.2011 Bulletin 2011/45**

(51) Int Cl.:
***H03K 3/0233*** *(2006.01)*

(21) Numéro de dépôt: **08163797.7**

(22) Date de dépôt: **05.09.2008**

(54) **Oscillateur de relaxation basse puissance**

Kippgenerator mit Niedrigspannung

Low-power relaxation oscillator

(84) Etats contractants désignés:
**AT BE BG CH CY CZ DE DK EE ES FI FR GB GR HR HU IE IS IT LI LT LU LV MC MT NL NO PL PT RO SE SI SK TR**

(43) Date de publication de la demande:
**10.03.2010 Bulletin 2010/10**

(73) Titulaire: **EM Microelectronic-Marin SA**
**2074 Marin (CH)**

(72) Inventeur: **Müller, Simon**
**3007 Bern (CH)**

(74) Mandataire: **Surmely, Gérard et al**
**ICB**
**Ingénieurs Conseils en Brevets SA**
**Faubourg de l'Hôpital 3**
**2001 Neuchâtel (CH)**

(56) Documents cités:
**EP-A- 0 407 269      US-A- 5 638 031**
**US-A- 6 157 270      US-A1- 2005 077 971**
**US-A1- 2007 279 137      US-B1- 7 034 627**
**US-B2- 6 720 836**

## Description

DOMAINE TECHNIQUE

L'invention concerne de manière générale un oscillateur de relaxation utilisé notamment dans des applications radiofréquences. L'invention concerne plus particulièrement un oscillateur de relaxation basse puissance pouvant être intégré dans un transpondeur de radio-identification (RFID).

ARRIERE-PLAN TECHNOLOGIQUE

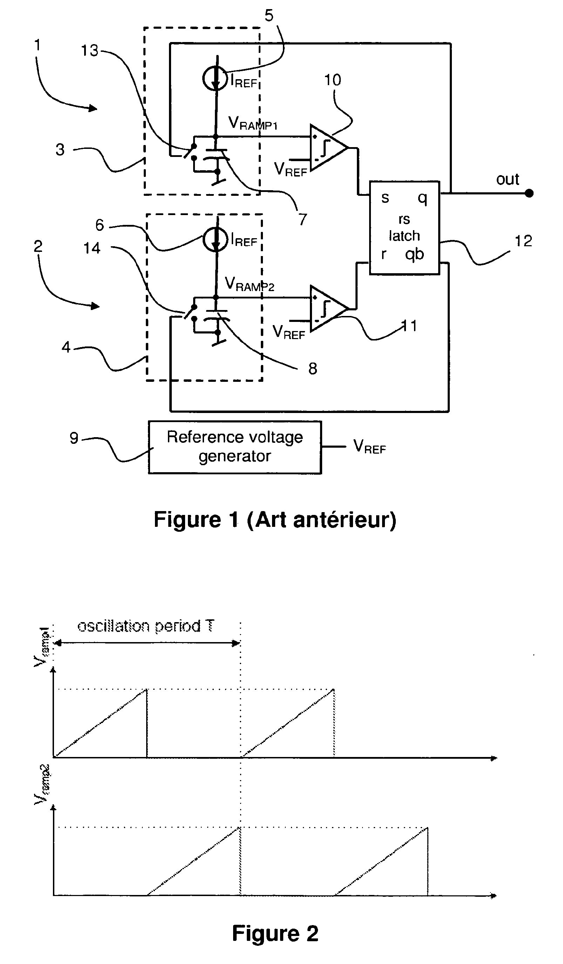

Il est connu dans l'art antérieur, un oscillateur de relaxation dont le schéma de base est fourni à la figure 1. Un tel oscillateur de relaxation comprend deux modules 1, 2 semblables comportant chacun un générateur de rampe 3, 4 formé par une source de courant de référence 5, 6 et une capacité de stockage 7, 8 définissant une tension de rampe ($V_{ramp1}$, $V_{ramp2}$), un générateur de tension de référence 9 et un comparateur de tension 10, 11 pour comparer la tension de rampe ($V_{ramp1}$, $V_{ramp2}$) à la tension de référence ($V_{ref}$). Une bascule asynchrone 12 de type RS reçoit à une première entrée (s) le signal de sortie du comparateur 10 du premier module et à une deuxième entrée (r) le signal de sortie du comparateur 11 du deuxième module 2. La bascule 12 fournit alors par le biais des bornes de sortie q et qb, alternativement des signaux de commande de charge de la capacité 7 du premier module et de charge de la capacité de stockage 8 du deuxième module. A cet effet, chaque générateur de rampe 3, 4 est commandé par l'intermédiaire d'un commutateur 13, 14.

Le fonctionnement d'un tel oscillateur de relaxation est décrit en liaison avec la figure 2 représentant les tensions de rampe ($V_{ramp1}$, $V_{ramp2}$) au cours du temps. Dans un premier temps, le commutateur 13 est ouvert, la source de courant de référence 5 charge la capacité de stockage 7 au moyen du courant de référence $1_{ref}$. Dans le même temps, le commutateur 14 est fermé de sorte que la capacité de stockage 8 est court-circuité et donc ne se charge pas. Lorsque la tension de rampe $V_{ramp1}$ atteint le niveau de la tension de référence $V_{ref}$, le comparateur de tension 10 le détecte et le signal qu'il fournit en sortie est modifié de sorte que la bascule 12 change d'état. Les signaux de sortie aux bornes q et qb sont inversés. De cette manière, les commutateurs 13 et 14 sont respectivement fermé et ouvert. La charge stockée sur la capacité 7 est alors déchargée à Vss par court-circuit, tandis que la charge de la capacité 8 commence. De la même manière, lorsque la tension de rampe $V_{ramp2}$ atteint le niveau de la tension de référence $V_{ref}$, le comparateur de tension 11 le détecte et le signal qu'il fournit en sortie est modifié de sorte que la bascule 12 change d'état. Les signaux de sortie aux bornes q et qb sont à nouveau inversés et le cycle initial peut recommencer. Ces deux phases de charge successivement de la capacité 7 et de la capacité 8 représentent une période d'oscillation.

Un autre oscillateur de relaxation selon l'art antérieur est décrit dans le document US°6,720,836. Ce document décrit un oscillateur de relaxation avec des sources de courant couplées entre elles.

Pour des applications de radio-identification faisant intervenir des transpondeurs RFID, la consommation des sources de courant utilisées dans de tels oscillateurs de relaxation est un des paramètres les plus critiques. La consommation de courant minimum théorique pour un tel oscillateur de relaxation est donnée par la formule $C* V_{ref}/ T = I_{ref}$. Pour minimiser la consommation de courant pour une période d'oscillation déterminée, la capacité de stockage C et la tension de référence $V_{ref}$ doivent être réduits au maximum. A cet effet, il est important de noter que la tension de référence $V_{ref}$ correspond à l'amplitude d'oscillation.

Les solutions existantes présentent un ou plusieurs des inconvénients listés ci-après, qui de ce fait les éloignent de la consommation minimum théorique.

Tout d'abord, un oscillateur tel que présenté à la figure 1, consomme l'équivalent de la consommation de courant théorique minimum rien qu'avec le générateur de rampe (via la source de courant de référence $I_{ref}$). Tous les autres circuits consommateurs vont donc éloignés un tel oscillateur de la consommation minimum théorique. Ces autres circuits consommateurs comprennent notamment le générateur de tension de référence, les comparateurs de la tension de rampe avec la tension de référence. Cette situation se rencontre par exemple dans les dispositifs décrits dans les documents US 7,034,627 et EP 0 407 269. Dans ces deux documents, la génération d'une tension de référence est obtenue dans une branche additionnelle, entre $V_{DD}$ et $V_{SS}$, dans laquelle est agencée une résistance au travers de laquelle passe un courant de référence définissant cette tenson de référence. Cette branche additionnelle est distincte et séparée de la branche de courant comprenant la capacité de stockage.

Un oscillateur tel que décrit dans le document US°6,720,836 présente l'inconvénient majeur d'avoir une amplitude d'oscillation liée à la tension grille-source $V_{gs}$ d'un transistor de type CMOS qui ne peut, de ce fait, être diminuée de manière à réduire la consommation de courant. En outre, un tel oscillateur de relaxation utilise un miroir de courant avec un rapport dimensionnel de 1 à 10 entre les transistors du miroir ce qui nécessite une importante surface sur un circuit intégré.

De plus, il est également à noter que l'amplitude de tension est égale à $V_{ref}$ seulement en théorie. En réalité, un phénomène de dépassement dû au temps de réaction des comparateurs apparaît dans les phases de commutation. Ceci est particulièrement le cas dans des solutions d'oscillateur utilisant des transistors qui ne fonctionnent pas pleinement en mode saturé.

Enfin, la valeur minimum pour la capacité de stockage est déterminée notamment par la valeur de la capacité parasite sur la plaque supérieure de la capacité de stockage. Ces capacités parasites viennent des connexions métalliques et des autres dispositifs connectés à la plaque supérieure de la capacité de stockage. Des solutions antérieures, basées notamment sur la boucle de Vittoz, relient de nombreux ou de larges dispositifs à cette capacité. Le fonctionnement de ces dispositifs en faible inversion augmente la capacité en comparaison d'un fonctionnement de ces dispositifs en forte inversion. Il sera donc important de veiller à garder une capacité de stockage limitée.

RESUME DE L'INVENTION

Un but de la présente invention est de répondre aux inconvénients mentionnés ci-dessus en fournissant un oscillateur de relaxation basse puissance, c'est-à-dire avec une consommation de courant réduite et le plus proche possible de la consommation minimum théorique sans compromettre la tension d'alimentation et la stabilité en température.

Dans ce but, un premier aspect de la présente invention concerne un oscillateur de relaxation basse puissance comprenant un premier module comportant un générateur de rampe formée par une source de courant et une capacité de stockage, alimentée par la source de courant via une branche de courant et définissant une tension de rampe, et un comparateur de tension pour comparer la tension de rampe à une tension de référence, un deuxième module semblable au premier module et une bascule asynchrone recevant, à une première entrée le signal de sortie du comparateur du premier module et, à une deuxième entrée, le signal de sortie du comparateur du deuxième module et fournissant en sortie alternativement des signaux de commande de charge de la capacité du premier module et de la capacité du deuxième module. Cet oscillateur de relaxation est **caractérisé en ce que**, pour chacun des premier et deuxième modules, un générateur de tension de référence est réalisé par adjonction d'une résistance de référence sur ladite branche de courant, de sorte que la tension de référence est définie par le courant fourni par ladite source de courant et traversant la résistance de référence.

Selon un mode de réalisation préféré, le comparateur est réalisé par un miroir de courant formé par deux transistors, dont l'un est intégré à la branche de courant entre la résistance de référence et la capacité de stockage et dont l'autre est intégré à une branche de courant de comparaison alimentée par une source de courant dynamique de comparaison.

Selon une variante avantageuse, le transistor présent dans la branche de courant de comparaison est agencé dans un montage en cascode avec un transistor supplémentaire.

Selon un autre mode de réalisation avantageux, la source de courant du premier module et celle du deuxième module est une seule et même source de courant utilisée en alternance pour alimenter respectivement le premier module et le deuxième module en fonction de signaux de commande délivrés à la sortie de la bascule asynchrone.

BREVE DESCRIPTION DES FIGURES

D'autres caractéristiques et avantages de la présente invention apparaîtront plus clairement à la lecture de la description détaillée qui suit de modes de réalisation de l'invention donnés à titre d'exemples nullement limitatifs et illustrés par les dessins annexés, dans lesquels :

- la figure 1, déjà décrite, représente un oscillateur de relaxation selon l'art antérieur ;

- la figure 2, déjà décrite, représente l'évolution des tensions de rampe d'un oscillateur de relaxation de base au cours du temps

- la figure 3 représente un oscillateur de relaxation basse puissance selon un premier mode de réalisation de la présente invention ;

- la figure 4 représente un oscillateur de relaxation basse puissance selon un deuxième mode de réalisation selon la présente invention.

DESCRIPTION DETAILLEE DE L'INVENTION

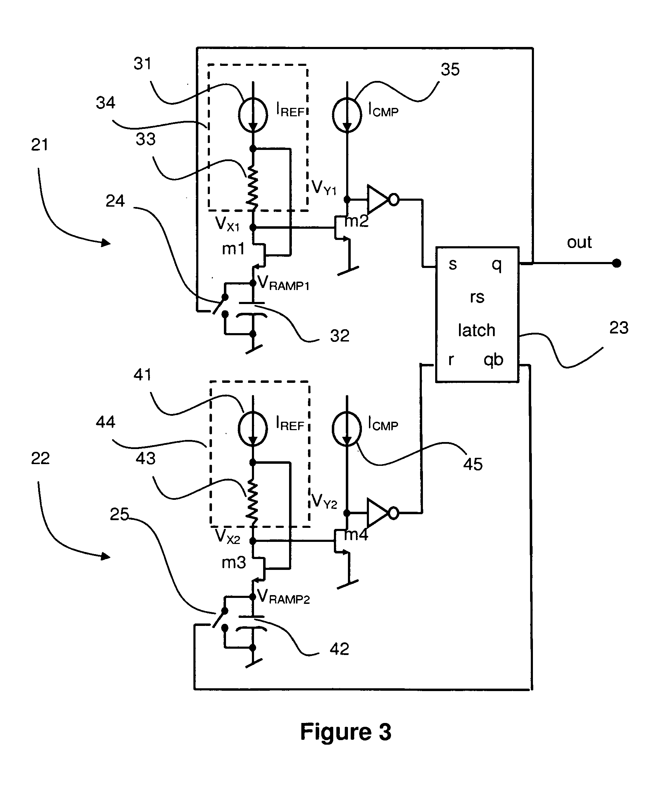

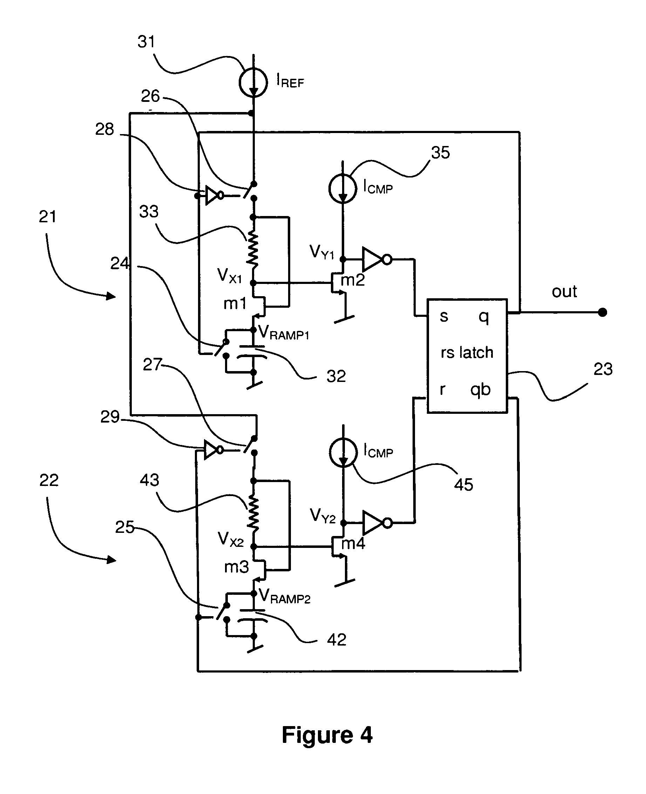

L'invention sera décrite ci-après uniquement à titre d'exemples non limitatifs en relation avec les figures 3 et 4. La figure 3 représente un oscillateur de relaxation basse puissance selon un premier mode de réalisation de la présente invention. La structure globale de l'oscillateur de relaxation selon ce premier mode de réalisation reste similaire à celle présentée en liaison avec l'oscillateur de relaxation de base selon l'art antérieur. On retrouve deux modules 21, 22 semblables comprenant chacun un générateur de rampe, un générateur d'une référence et un comparateur. La sortie de chacun de ces deux modules est ensuite reliée aux bornes d'entrée d'une bascule asynchrone 23 dont les sorties sont rebouclées sur l'entrée de l'un et l'autre des modules. Toutefois, la présente invention diffère de l'oscillateur selon l'art antérieur dans la réalisation des modules. En particulier, il est prévu une combinaison avantageuse du générateur de rampe avec le générateur d'une tension de référence et le comparateur de sorte à réduire au minimum la consommation de courant du module.

Nous allons maintenant décrire en détail le premier module 21, description qui sera valable de la même manière pour le deuxième module 22. Le générateur de rampe reste basé sur le principe de charger une capacité de stockage 32 au moyen d'un courant de référence $I_{ref}$ issu d'une source de courant de référence 31.

Le générateur d'une tension de référence 34 est avantageusement intégré dans le générateur de rampe par l'introduction d'une résistance de référence 33 en série de la source de courant de référence 31. Ainsi la résistance est traversée par le courant de référence $I_{ref}$ de sorte que la tension à ses bornes devient une tension de référence $V_{ref}$. On notera à cet effet que l'on peut arbitrairement choisir l'amplitude des oscillations par le choix de la résistance de référence.

Dans le même temps, le comparateur est formé par deux transistors m1 et m2, dont le premier transistor m1 est intégré dans la branche de courant de référence, i.e. celle traversée par le courant de référence $I_{ref}$, de sorte qu'il n'entraîne aucune consommation additionnelle de courant et dont le second transistor est intégré dans une branche de courant de comparaison alimentée par une source de courant dynamique de comparaison 35, i.e. dont le courant de comparaison $I_{cmp}$ est produit et consommé uniquement durant les courts instants de comparaison. Les deux transistors m1 et m2 forment ainsi un miroir de courant. Plus spécifiquement, les bornes de courant (source et drain) du premier transistor m1 sont connectées entre la résistance de référence 33 et la capacité de stockage 32 et la borne de commande (grille) est connectée entre la résistance de référence 33 et la source de courant de référence 31. Le transistor m1 est utilisé en forte inversion. En ce qui concerne le transistor m2, ses bornes de courant sont connectées entre la masse, en particulier $V_{ss}$, et la source de courant dynamique de comparaison 35 et sa borne de commande est connectée à la branche de courant de référence entre la résistance de référence et le transistor m1. On notera que la capacité 32 est également connectée à la masse, i.e. à la même tension de référence qu'une borne de courant du transistor m2. Le transistor m2 est en saturation pendant la comparaison lorsque la sortie du comparateur, définie par la borne de courant (drain) reliée à la source de courant de comparaison, est proche de la tension de référence $V_{dd}$ au début de la comparaison. La sortie du comparateur est de préférence amplifiée dans un inverseur (ou plusieurs dans une variante), faible consommateur de courant, puis fournie en entrée d'une bascule asynchrone 23.

La bascule asynchrone est par exemple du type RS. Cette bascule 23 reçoit ainsi à une première entrée (s) la sortie du comparateur du premier module 21 et à une deuxième entrée (r) la sortie du comparateur du deuxième module 22 et fournit en sortie des signaux de commande pour charger alternativement la capacité de stockage du premier module et la capacité de stockage du deuxième module, par l'intermédiaire des sorties opposées (q) et (qb) venant commuter en alternance des commutateurs 24 et 25.

Un tel oscillateur s'avère très avantageux en ce qu'il nécessite uniquement une source de courant de référence permettant de charger la capacité de stockage, d'une part, et de fournir la tension de référence pour le comparateur d'autre part. En outre, le comparateur est intégré de sorte que le premier transistor m1, celui dans la branche de courant de référence, ne consomme pas de courant supplémentaire et que le deuxième transistor m2, celui dans la branche de courant dynamique, ne consomme du courant que lors de la transition du comparateur lorsque la tension de rampe atteint la tension de référence.

Nous allons maintenant décrire le fonctionnement de l'oscillateur de relaxation de la figure 3 au cours du temps. A cet effet, les tensions importantes à considérer sont les tensions de rampe $V_{ramp1}$ et $V_{ramp2}$, en comparaison de la tension de référence $V_{ref}$ ainsi que le potentiel des noeuds $V_{x1}$, $V_{y1}$ pour ce qui concerne le premier module 21 et $V_{x2}$, $V_{y2}$ en ce qui concerne le deuxième module 22.

La tension au noeud $V_{x1} = V_{ramp1} + V_{gs} - V_{ref}$ avec $V_{gs}$ qui est la tension grille - source du transistor m1 et $V_{ref}$ qui est la tension de référence soit $I_{ref} * R$. Au début, le commutateur 24 est fermé, court-circuitant la capacité de stockage 32 qui est alors déchargée. Le transistor m1 est conducteur tandis que le transistor m2 est non conducteur. Ainsi la tension de rampe $V_{ramp1}$ est nulle ainsi que le courant de comparaison $I_{cmp}$. Dans le même temps, la tension au noeud $V_{y1} = V_{dd}$. On comprend que la présence de la source de courant dynamique de comparaison permet de garder le noeud $V_{y1}$ à une tension définie ($V_{dd}$) sans pour autant consommer de courant en dehors de la comparaison, c'est-à-dire lors de la transition qui va être expliquée ci-après.

Ensuite sur instruction de la bascule via le signal de commande q, le commutateur 24 s'ouvre et parallèlement via le signal de commande qb, le commutateur 25 se ferme. Dès lors la capacité de stockage 32 du premier module 21 est chargée et parallèlement la tension $V_{ramp1}$ augmente et la capacité de stockage 42 du second module 22 est brutalement déchargée en raison du court-circuit réalisé par le commutateur 25. Le deuxième module 22 se trouve alors dans l'état initial décrit ci-dessus pour le premier module, i.e. $V_{ramp2} = 0$ et $V_{y2} = V_{dd}$. Le signal fournit en sortie du deuxième module 22 à la bascule 23 est alors inversé.

Lorsque la tension de rampe $V_{ramp1}$ atteint le niveau de la tension de référence $V_{ref}$, la tension au noeud $V_{x1}$ devient égale à la tension $V_{gs}$. Dès lors le transistor m2 devient conducteur. En conséquence de quoi, la tension au noeud $V_{y1}$ tombe à $V_{ss}$. Le signal fournit en sortie du comparateur du premier module à la bascule 23 est donc inversé. Le signal reçu à la borne d'entrée (s) de la bascule ayant été inversé, les sorties q et qb sont inversées à leur tour, de sorte que le commutateur 24 est fermé. le signal reçu à la borne d'entrée (r) de la bascule est alors inversé à son tour. Un cycle semblable à celui juste décrit pour le premier module commence pour le deuxième module et ainsi de suite. On retrouve une évolution des tensions de rampe au cours du temps similaire à celle présentée à la figure 2. La période d'oscillation est donnée par la formule :

$$T = C * V_{ref} / I_{ref} \; ;$$

dans la mesure où $V_{ref} = R * I_{ref}$, la formule précédente peut s'écrire :

$$T = R * C.$$

Ainsi la période d'oscillation T dépend seulement de la résistance R de référence et de la capacité de stockage C. Le coefficient de température de la capacité est généralement négligeable et celui de la résistance est relativement petit. Ainsi on obtient donc un oscillateur à consommation réduite sans pour autant perturber la tension d'alimentation et la stabilité en température.

La figure 4 représente un oscillateur de relaxation basse puissance selon un deuxième mode de réalisation de la présente invention. Ce mode de réalisation est semblable en tout point au mode représenté à la figure 3, à l'exception des sources de courant de référence utilisées. Dans cet oscillateur selon ce deuxième mode, il est avantageusement prévu, en vue de réduire encore plus la consommation de courant, de n'utiliser qu'une seule source de courant de référence 31 commune aux deux modules 21 et 22. Pour cela, des commutateurs 26 et 27 sont intégrés entre la source commune de courant de référence 31 et la résistance de référence 33 du premier module, respectivement la résistance de référence 43 du second module. Des inverseurs 28 et 29 sont prévus pour commander ces deux commutateurs 26 et 27 pour assurer que la source de courant de référence fournisse le courant pour charger la capacité 32, alternativement 42, lorsqu'elles ne sont pas court-circuitées.

On comprendra que diverses modifications et / ou améliorations évidentes pour l'homme du métier peuvent être apportées aux différentes modes de réalisation de l'invention décrits dans la présente description sans sortir du cadre de l'invention défini par les revendications annexées. En particulier, on pourra utiliser un montage cascode en lieu et place du transistor (m2, m4) présent dans la branche de courant de comparaison des modules.

**Revendications**

1. Oscillateur de relaxation basse puissance comprenant un premier module (21) comportant un générateur de rampe formée par une source de courant (31) et une capacité de stockage (32), alimentée par la source de courant via une branche de courant et définissant une tension de rampe ($V_{ramp1}$), et un comparateur de tension (m1, m2) pour comparer la tension de rampe à une tension de référence, un deuxième module (22, 41, 42, $V_{ramp2}$, m3, m4) semblable au premier module et une bascule asynchrone (23) recevant, à une première entrée (s), le signal de sortie du comparateur du premier module et, à une deuxième entrée (r), le signal de sortie du comparateur du deuxième module et fournissant en sortie alternativement des signaux de commande de charge de la capacité du premier module et de la capacité du deuxième module, **caractérisé en ce que**, pour chaque module, un générateur de ladite tension de référence est réalisé par adjonction d'une résistance de référence (33, 43) sur ladite branche de courant, de sorte que la tension de référence ($V_{ref}$) est définie par le courant ($I_{ref}$) fourni par ladite source de courant et traversant cette résistance de référence.

2. Oscillateur de relaxation selon la revendication 1, **caractérisé en ce que** le comparateur est réalisé par un miroir de courant formé par deux transistors, dont un premier (m1, m3) est intégré à ladite branche de courant entre la résistance de référence et la capacité de stockage et dont le second (m2, m4) est intégré à une branche de courant de comparaison alimentée par une source de courant dynamique de comparaison (35, 45).

3. Oscillateur de relaxation selon la revendication 2, **caractérisé en ce que** la borne de commande du premier transistor (m1, m3) est connectée entre ladite résistance de référence et ladite source de courant.

4. Oscillateur de relaxation selon la revendication 2 ou 3, **caractérisé en ce que** le second transistor (m2, m4) est agencé dans un montage en cascode avec un transistor supplémentaire.

5. Oscillateur de relaxation selon l'une des revendications 1 à 4, **caractérisé en ce que** ladite source de courant du premier module et celle du deuxième module est une seule et même source de courant utilisée en alternance pour alimenter respectivement le premier module et le deuxième module en fonction de signaux de commande délivrés à la sortie de la bascule asynchrone.

**Claims**

1. Low-power relaxation oscillator comprising a first module (21) having a ramp generator formed by a current source (31) and stowage capacitor (32) supplied by the current source via a current branch and defining a ramp voltage ($V_{ramp1}$), and a voltage comparator (m1, m2) for comparing the ramp voltage with a reference voltage, a second module (22, 41, 42, $V_{ramp2}$, m3, m4) similar to the first module and an synchronous flip-flop (23) receiving the output signal of the comparator of the first module at a first input (s) and the output signal of the comparator of the second module at a second input (r) and alternately outputting control signals for charging the capacitor of the first module and the capacitor of the second module, **characterised in that** for each module a generator of said reference voltage is configured by adding a reference resistance (33, 43) on said current branch in such a manner that the reference voltage ($V_{ref}$) is defiled by the current ($I_{ref}$) provided by said current source and flowing through this reference resistance.

2. Relaxation oscillator according to claim 1, **characterised in that** the comparator is configured by a modified current mirror comprising two transistors, of which a first (m1, m3) is integrated into said current branch between the reference resistance and the storage capacitor and the second (m2, m4) is integrated into a comparison current branch supplied by a source of dynamic comparison current (35, 45).

3. Relaxation oscillator according to claim 2, **characterized in that** the control gate of the first transistor (m1, m3) is connected between said reference resistance and said current source.

4. Relaxation oscillator according to claim 2 or 3, **characterised in that** said second transistor (m2, m4) is arranged in a cascode configuration with an additional transistor.

5. Relaxation oscillator according to one of claims 1 to 4, **characterised in that** said current source of the first module and that of the second module is the very same current source used to alternately supply the first and the second module respectively on the basis of control signals delivered to the output of the asynchronous flip-tlop.

**Patentansprüche**

1. Relaxationsoszillator geringer Leistung umfassend ein erstes Modul (21) mit einem Rampengenerator, welcher von einer Stromquelle (31) und einer Speicherkapazität (32) gebildet ist, die von der Stromquelle über einen Stromzweig versorgt wird und die eine Rampenspannung ($V_{ramp1}$) definiert, und mit einem Spannungskomparator (m1, m2) um die Spannung der Rampe mit einer Referenzspannung zu vergleichen, ferner mit einem zweiten Modul (22, 41, 42, $V_{ramp2}$, m3, m4) vergleichbar dem ersten Modul und mit einer asynchronen Wippe (23), welche an einem ersten Eingang (s) ein Ausgangssignal des Komparators des ersten Moduls und welche an einem zweiten Eingang (r) das Ausgangssignal des Komparators des zweiten Moduls erhält und die am Ausgang abwechselnd Steuersignale der Ladung der Kapazität des ersten Moduls und der Kapazität des zweiten Moduls erzeugt, **dadurch gekennt-**

**zeichnet, dass** für jedes Modul ein Generator der Referenzspannung durch Hinzufügen eines Referenzwiderstandes (33, 43) im Stromzweig derart verwirklicht wird, dass die Referenzspannung ($V_{ref}$) vom Strom ($I_{ref}$) definiert wird, welcher von der Stromquelle erzeugt wird und durch den Referenzwiderstand fließt.

2. Relaxationsoszillator nach Anspruch 1, **dadurch gekennzeichnet, dass** der Komparator durch einen Stromspiegel verwirklicht wird, welcher von zwei Transistoren gebildet wird, von denen ein erster (m1, m2) in dem Stromzweig zwischen dem Referenzwiderstand und der Speicherkapazität integriert ist von denen ein zweiter (m2, m4) in einen Vergleichsstrornzweig integriert ist, welcher von einer dynamischen Vergleiehs-Strornquelle (35, 45) versorgt wird.

3. Ftclaxationsoszillator nach Anspruch 2, **dadurch gekennzeichnet, dass** der Steueranschluss des ersten Transistors (m1, m3) zwischen dem Referenzwiderstand und der Stromquelle angeschlossen ist.

4. Relaxationsoszillator nach Anspruch oder 3, **dadurch gekennzeichnet, dass** der zweite Transistor (m2, m4) in einer Kaskadenschaltung mit einem Zusatztransistor angeordnet ist.

5. Relaxationsoszillator nach einem der Ansprüche 1 bis 4, **dadurch gekennzeichnet, dass** die Stromquelle des ersten Moduls und diejenige des zweiten Moduls eine einzige und gemeinsame Stromquelle ist, die abwechselnd zur Versorgung des ersten Moduls und des zweiten Moduls verwendet wird, zum dementsprechend die Steuersignale am Ausgang der asynchronen Wippe bereitzustellen.

**Figure 1 (Art antérieur)**

**Figure 2**

**Figure 3**

**Figure 4**

# EP 2 161 837 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6720836 B
- US 7034627 B
- EP 0407269 A